# EUROPEAN PATENT APPLICATION

(11) **EP 2 087 981 A1**
(43) Date of publication of application: **12.08.2009**
(21) Application number: 07830161.1
(22) Date of filing: 19.10.2007
(51) Int. Cl.: B29C 33/42, B29C 33/38, B81C 5/00, G01N 37/00

(54) **MASTER AND MICROREACTOR**

(30) Priority: 31.10.2006 JP 2006296297
(71) Applicant: Konica Minolta Opto, Inc., Hachioji-shi, Tokyo 192-8505 (JP)
(72) Inventor: SEKIHARA, Kanji, Hachioji-shi Tokyo 192-8505 (JP); UEHIRA, Masayoshi, Hachioji-shi Tokyo 192-8505 (JP)
(74) Representative: Henkel, Feiler & Hänzel
(86) International application number: PCT/JP2007/070427
(87) International publication number: WO 2008/053720

(57) **Abstract**

Mold releasability of a master from a molding metal die is improved. A master (40) is a base body of the molding metal die. The master has a groove (43) equivalent to a flow channel of a resin molded product, and the cross-section of the bottom surface portion (43a) of the groove (43) has a curved surface.

## Description

### TECHNICAL FIELD

The present invention relates to a master that represents a mother body for a molding die and to a microreactor produced by the master.

### BACKGROUND

In recent years, in the testing field such as a blood test, a microreactor is used to inspect reactions and changes in liquid samples which are different in terms of a type and are mixed in a microscopic flow channel. Though the microreactor is generally constituted of glass or the like in many cases, it is also possible to produce it through injection molding by using a molding die.

An example of a manufacturing method for the aforesaid molding die is disclosed in Patent Literature 1. In the technology disclosed in Patent Literature 1, a master (which is a mother body for the die and has recess and projection forms which are the same as those of a resin molded product) is produced through photolithography and etching, and a molding die is produced by the master through electrocasting processing or the like, and in particular, mold releasability of molding die from the master is improved by forming a specific conductive film on a surface of the master (11th line in lower paragraph on the right side on page 3 - 11th line in upper paragraph on the left side on page 4).
Patent Literature 1: Unexamined Japanese Patent Application Publication No. 4-195941

### DISCLOSURE OF THE INVENTION

### PROBLEMS TO BE SOLVED BY THE INVENTION

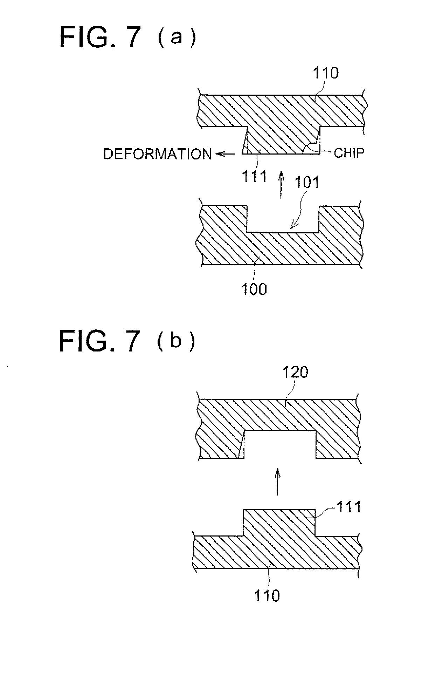

However, in the technology disclosed in Patent Literature 1 wherein recess portion 101 is formed on the master 100 as is shown in Fig. 7(a), projection portion 111 of molding die 110 may be deformed by the influence of a shape of recess portion 101 (undercut form) or by an error of squareness and straightness during releasing or is chipped by the influence of releasing resistance with the recess portion 101, when the molding die 110 is released from the master 100, because the recess portion 101 is in a rectangular shape. In addition, the projection portion 111 of the molding die 110 is made in the rectangular form as shown in Fig. 7(b) according to the recess portion 101 of the master 100, and resin molded product 120 has also a possibility to be deformed when resin molded product 120 is released from the molding die 110.

An objective of the invention is to improve mold releasability between the master and the molding die.

### METHOD TO SOLVE THE PROBLEMS

The first invention to solve the aforesaid problem is a master to be a mother body for a molding die wherein the master has grooves corresponding to flow channels of resin molded product, and a cross-section of the grooves is curved or is bent.

In the master relating to the first invention, a cross-section of a bottom surface portion of the aforesaid groove may also be in the form of a curved surface, or a cross-section of a side surface portion of the aforesaid groove may also be in the form of a slope or in the form of a curved surface. A bottom surface portion and a side surface portion of the aforesaid groove may also be in the form of a semicircle, or a corner portion of the aforesaid groove may also be in the form of a curved surface. Further, a cross-section of a bottom surface portion in the lengthwise direction of the aforesaid groove may also be in the form of a step, the form of a slope or the form of a curved surface, or a cross-section of an edge portion of the aforesaid groove may also be in the form of a curved surface, a slope or a step.

The second invention is a microreactor that has a substrate and a covering body that covers the substrate both of which are bonded together wherein the aforesaid substrate is produced with a master described in any one of Claims 1 - 7.

### EFFECTS OF THE INVENTION

In the first invention, a cross-section of the groove of the master is curved or bent, which prevents a projection portion of the molding die, when the molding die is released from the master, from being deformed due to a shape of a groove on the master and an error of squareness and straightness during the releasing and from being chipped by an influence of resistance for the releasing from grooves of the master, thus, mold releasability of the molding die from the master can be improved.

In the second invention, flow channels identical to the grooves of the master in terms of a shape are formed on the substrate, and when the flow channels are in forms described in Claims 2 - 6 in particular, it is possible to control the flow velocity of liquid samples which flow through the flow channels without changing a width of the flow channels. On the other hand, when a flow channel of the substrate is in a form that is described in Claim 7, it is possible to prevent excessive resin components and adhesives from being infiltrated into the flow channel, when thermal adhesion technology and adhesives are used for gluing a substrate and a covering body together.

### BRIEF DESCRIPTION OF THE DRAWINGS

Fig. 1 is a perspective view showing a schematic structure of microreactor 1.
Fig. 2 is a sectional view showing a schematic structure of master 40.
Fig. 3 is a sectional view showing an example of a variation of groove 43.
Fig. 4 is a sectional view showing an example of a variation of groove 43.
Fig. 5 is a diagram showing a process of a part of a manufacturing method for microreactor 1.
Fig. 6 is a diagram for illustrating specific effects offered by a shape of substrate 2 of microreactor 1.
Fig. 7 is a diagram for illustrating problems in the prior art.

### DESCRIPTION OF SYMBOLS

1. Microreactor
2. Substrate
21, 22. Inflow channel
23. Reaction flow channel
24, 25. Outflow channel
3. Covering body
31, 32. Inflow channel
34, 35. Outflow channel
40. Master
41. Master blank
42. Plated layer
43. Groove
43a. Bottom surface portion
43b. Side surface portion
43c. Corner portion
43d. Edge portion

### BEST MODE FOR CARRYING OUT THE INVENTION

The best mode for carrying out the present invention will be described as follows, referring to the drawings. However, various types of limitations which are preferable technically for carrying out the invention are given in the embodiments which will be described below, and the scope of the invention is not limited to the following embodiments and to the following illustrated examples.

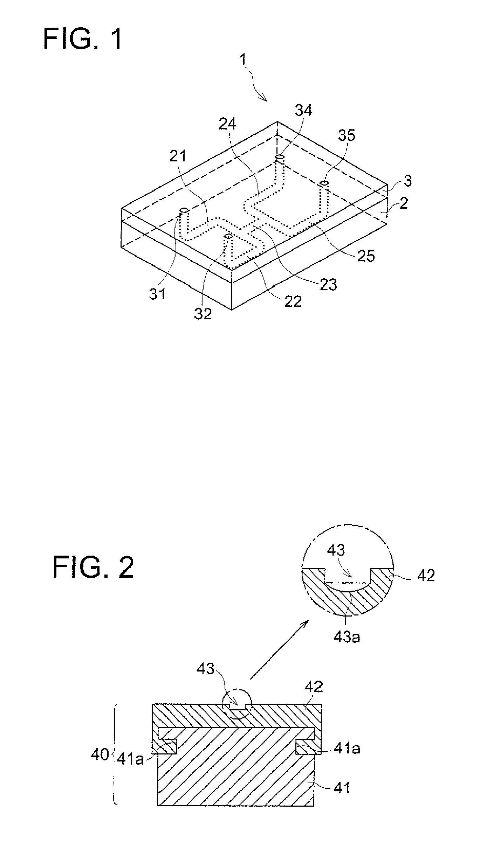

First, "a microreactor" and "a master" relating to the invention will be described, referring to Fig. 1 - Fig. 3.

As shown in Fig. 1, microreactor 1 has therein substrate 2 and covering body 3 each of which is in the form of a rectangular parallelepiped substantially. The substrate 2 and the covering body 3 are made of resin, and the covering body 3 is pasted on the substrate 2.

As shown by dotted lines in Fig. 1, on a surface of the substrate 2, inflow channels 21 and 22, reaction flow channel 23, and outflow channels 24 and 25 are formed. On the merging section for the inflow channels 21 and 22, an end portion on one side of reaction flow channel 23 is connected, and to the end portion on the other side of reaction flow channel 23, the merging section for the outflow channels 24 and 25 is connected. These inflow channels 21 and 22, reaction flow channel 23 and outflow channels 24 and 25 are grooves (micro flow channels) which are extremely microscopic.

Inflow entrances 31 and 32 and outflow exits 34 and 35 are formed on the covering body 3. The inflow entrances 31 and 32 are communicated respectively with the inflow channels 21 and 22, while, the outflow channels 34 and 35 are communicated respectively with the outflow channels 24 and 25. When liquids are caused to flow from the inflow entrances 31 and 32, respective liquids flow through the inflow channels 21 and 22 to be merged, and are mixed in the reaction flow channel 23 to be branched to outflow channels 24 and 25, to flow out of the outflow exits 34 an 35. Under this constitution, microreactor 1 is used favorably for mixing liquid samples such as blood and medicines which are different each other in terms of types.

As is shown in Fig. 2, master 40 is a mother body of a molding die for substrate 2 of microreactor 1, and it has master blank 41 that is in the shape of a rectangular parallelepiped substantially. On the master blank 41, groove 41a is formed along the outer circumference of the master blank 41. Plated layer 42 is formed on the master blank 41 to hold the master blank 41 from one side surface to the other side surface thereof, and groove 43 is formed on the plated layer 42. The groove 43 corresponds to inflow channels 21 and 22, reaction flow channel 23, and outflow channels 24 and 25, and it is a groove formed by machining process and is extremely microscopic.

As is shown by an enlarged diagram in Fig. 2, bottom surface portion 43a of the groove 43 is in the shape of a curved surface, and it is of the structure in which the molding die can easily be released from the master 40.

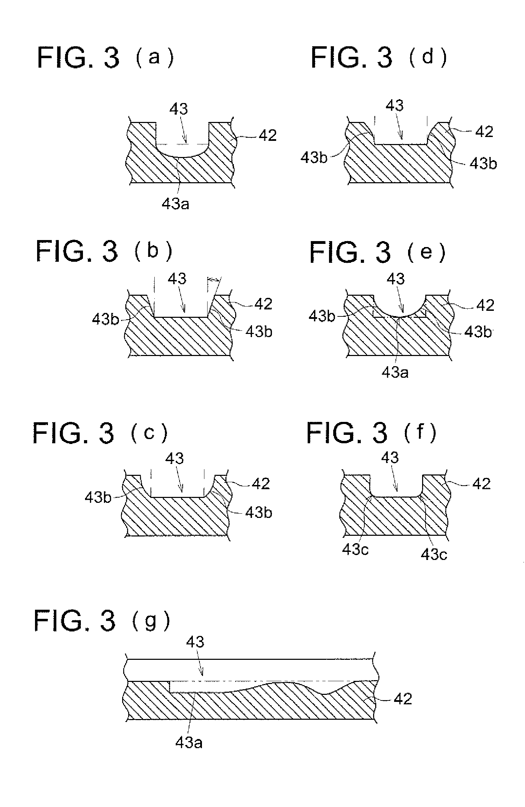

With respect to the groove 43, (1) the bottom surface portion 43a may also be in the form of another curved surface that is different from Fig. 2 as shown in Fig. 3(a), (2) side surface portion 43b may also be in the form of a slope as shown in Fig. 3(b), (3) the side surface portion 43b may also be in the form of a curved surface as shown in Figs. 3(c) and 3(d), (4) the bottom surface portion 43a and the side surface portion 43b may also be in the form of a hemisphere face as shown in Fig. 3(e), (5) corner portion 43c may also be in the form of a curved surface as shown in Fig. 3(f), (6) the bottom surface portion 43a may also be in the form of a step, or of a slope or of a curved surface in its length direction as shown in Fig. 3(g). When the groove 43 has the cross-sectional form shown in Fig. 3(b), it is preferable that an angle formed by side surface portion 43b and the perpendicular line is about 0 - 10°, and when the groove 43 has the cross-sectional form shown in Fig. 3(f), it is preferable that a radius of curvature on corner portion 43c is about 0.02 - 10 µm.

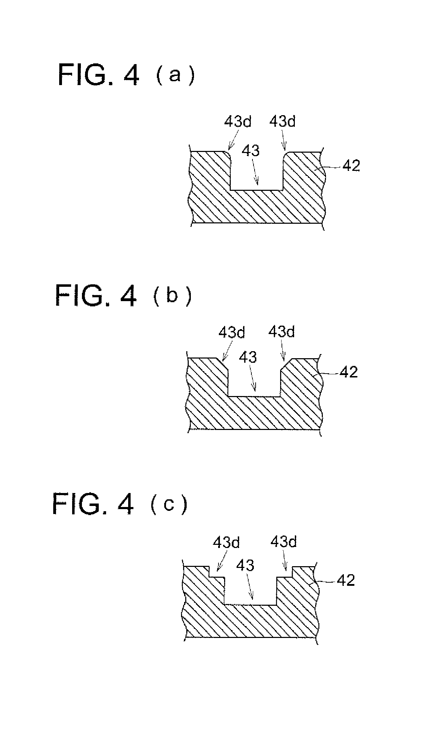

With respect to the groove 43, edge portion 43d may also be in the form of a curved surface as shown in Fig. 4(a), edge portion 43d may also be in the form of a slope as shown in Fig. 4(b) and edge portion 43d may also be in the form of a step as shown in Fig. 4(c).

The shape of the groove 43 may also be a combination of respective shapes shown in Fig. 2 - Fig. 4 properly, and a cross-section of the groove 43 has only to be curved or bent, eventually.

Meanwhile, each of grooves 43 shown in Fig. 2, Figs. 3(a) - 3(f) and Figs. 4(a) - 4(c) indicates a shape after cutting in the direction perpendicular to the lengthwise direction of each groove, and groove 43 shown in Fig. 3(g) indicates a shape after cutting in the lengthwise direction of the groove.

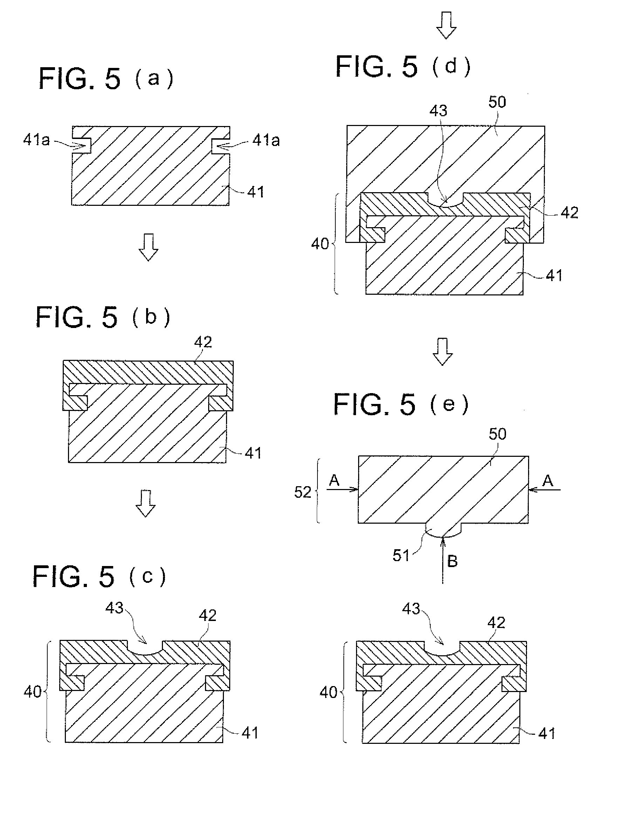

Next, "a manufacturing method for a microreactor" relating to the invention will be described as follows, referring to Fig. 5.

Roughly speaking, the manufacturing method includes manufacturing of a molding die from master 40, manufacturing of substrate 2 by forming resins with the molding die and gluing together of the substrate 2 and covering body 3. In other words, the substrate 2 is produced from master 40. Each process of the manufacturing method will be described in detail as follows.

First, master blank 41 shown in Fig. 5(a) is prepared. After that, plated layer 42 is formed by conducting Ni-P plating processing and Cu plating processing on the master blank 41 as shown in Fig. 5(b). The plated layer 42 is formed to hold master blank 41 from one side surface to the other side surface of master blank 41 owing to groove 41a, so that the master blank 41 and the plated layer 42 hardly peel off each other.

After that, as is shown in Fig. 5(c), machining process is conducted on the top surface of the plated layer 42, and groove 43 is formed to complete master 40. The master 40 is a mother body of the molding die of substrate 2, and the groove 43 corresponds to inflow channels 21 and 22, reaction flow channel 23 and outflow channels 24 and 25 of the substrate 2.

Incidentally, the plated layer 42 does not need to be on the master 40, and for example, it is possible to prepare master blank 41 by using a homogeneous material such as aluminum alloy or oxygen-free copper as a material so that the master blank 41 may serve as master 40.

After that, as is shown in Fig. 5(d), an oxide film (not shown) is formed on top of the plated layer 42 of master 40, and electrocasting processing is conducted on top of the oxide film to form thick electrocasting processed object 50 so that the plated layer 42 may be covered thereby. The reason of forming the oxide film on top of the plated layer 42 before electrocasting processing is to make the electrocasting processed object 50 to be released easily from the master 40.

After that, under the condition that the electrocasting processed object 50 is not released from the master 40, an outer shape of the electrocasting processed object 50 is applied with machining process additionally, as is shown by arrow A in Fig. 5(e), and the lateral of the electrocasting processed object 50 is removed until the moment when the lateral side of the electrocasting processed object 50 is aligned with the lateral side of the master 40 (plated layer 42).

After that, as is shown by arrow B in Fig. 5(e), the electrocasting processed object 50 which has been processed by machining additionally is released from the master 40, and the aforesaid oxide film interposed between a bottom surface (transfer surface) of the electrocasting processed object 50 and an upper surface of the plated layer 42 of the master 40 is removed. As a result, molding die 52 equipped with projection portion 51 corresponding to the groove 43 of the master 40 can be produced.

Afterwards, the molding die 52 is mounted on a base mold. The molding die 52 can be mounted on the base mold by means of adhesives, screw cramp, cramp fixing or suction and others.

After that, substrate 2 is produced from a resin such as thermoplastic resin through injection molding on the molding die 52, and finally, the substrate 2 and covering body 3 are glued together through thermofusion or by adhesives, thus, microreactor 1 can be produced.

In the aforesaid present embodiment, bottom surface portion 43a of groove 43 of the master 40 is in the form of a curved surface. Therefore, when the electrocasting processed object 50 is released from the master 40, it is possible to prevent projection portion 51 of the electrocasting processed object 50 from being deformed because of the shape of groove 43 of the master 40 or an error of squareness and straightness in the releasing, or from being chipped by an influence of releasing resistance against groove 43 of the master 40, thus, mold releasability between the master 40 and molding die 52 can be improved.

When forming groove 43 of master 40, machining process is conducted on the plated layer 42, whereby, the degree of freedom for microscopic processing is greater than that in the case of forming the groove 43 through photolithography and etching, which eliminates the need for a clean room, a UV cut room and wastewater-treatment equipment which are needed in the case of photolithography and etching.

Further, in the present embodiment, each of the forms of inflow channels 21 and 22, reaction flow channel 23 and outflow channels 24 and 25 on substrate 2 is the same as that of the groove 43 of the master 40. Therefore, if groove 43 having the form in Fig. 2 - Fig. 3 is formed on the plated layer 42, it is possible to control the flow velocity of liquid samples which flow through the inflow channels 21 and 22, the reaction flow channel 23 and the outflow channels 24 and 25, without changing a width of the flow channel, and it is possible to cause the inflow channels 21 and 22, the reaction flow channel 23 and the outflow channels 24 and 25 to function effectively for uniform circulation, mixing and branching of the liquid samples. For example, a form of flow channel that is suitable for changing the flow velocity at an inflow section, a mixing section or an outflow section for the liquid samples, suitable for generating a turbulent flow and a laminar flow on purpose or suitable for adding various functions such as lens function and a micro-pump function partially can be created.

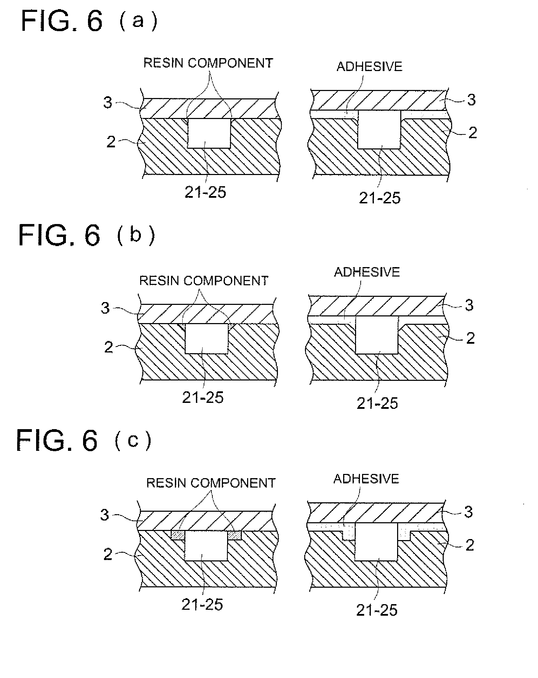

On the other hand, if groove 43 having the form in Fig. 4 is formed on the plated layer 42, when thermofusion or a adhesive is used for the adhesion of substrate 2 and covering body 3, excessive resin components or adhesives is collected on the edge portion (corresponding to edge portion 43d in Fig. 4) where substrate 2 comes into contact with covering body 3, as is shown in Figs. 6(a) - 6(c), and the excessive resin components or adhesives can be prevented from intruding into the inflow channels 21 and 22, the reaction flow channel 23 and the outflow channels 24 and 25.

## Claims

1. A master which is a mother body of a molding die, the master comprising:
a groove corresponding to a flow channel of a resin molded product,
wherein a cross section of the groove is curved or bent.

2. The master of claim 1,
wherein a cross section of a bottom surface portion of the groove is in a form of a curved surface.

3. The master of claim 1,
wherein a cross section of a side surface portion of the groove is in a form of a slope or a curved surface.

4. The master of claim 1,
wherein a bottom surface portion and a side surface portion of the groove are in a form of a semicircle.

5. The master of claim 1,
wherein a corner portion of the groove is in a form of a curved surface.

6. The master of any one of claims 1 - 5,
wherein a cross section of a bottom surface portion in a lengthwise direction of the groove is in a form of a step, a slope or a curved surface.

7. The master of any one of claims 1 - 6,
wherein a cross section of an edge portion of the groove is in a form of a curved surface, a slope or a step.

8. A microreactor comprising:
a substrate;
a covering body which covers the substrate,
wherein the substrate and the covering body are bonded together, and
wherein the substrate is made by the master of any one of claims 1 - 7,
